# EUROPEAN PATENT APPLICATION

(11) **EP 3 750 969 A1**
(43) Date of publication of application: **16.12.2020**
(21) Application number: 18905655.9
(22) Date of filing: 06.12.2018
(51) Int. Cl.: C09K 3/14, B24D 3/00, C04B 35/5831, C04B 35/628

(54) **SUPERABRASIVE AND SUPERABRASIVE WHEEL**

(30) Priority: 08.02.2018 JP 2018020958
(71) Applicant: Sumitomo Electric Industries, Ltd., Osaka-shi, Osaka 541-0041 (JP); A.L.M.T. Corp., Minato-ku Tokyo 105-0014 (JP)
(72) Inventor: ISHII, Akito, Osaka-shi, Osaka 541-0041 (JP); OKAMURA, Katsumi, Osaka-shi, Osaka 541-0041 (JP); NAKAMURA, Tomokazu, Kato-shi, Hyogo 679-0221 (JP); NAKAMURA, Nobuhide, Kato-shi, Hyogo 679-0221 (JP)
(74) Representative: Boult Wade Tennant LLP
(86) International application number: PCT/JP2018/044911
(87) International publication number: WO 2019/155749

(57) **Abstract**

There is provided a super-abrasive grain including: a body composed of cubic boron nitride or diamond; and a ceramic coating film coating at least a portion of a surface of the body.

## Description

### TECHNICAL FIELD

The present disclosure relates to super-abrasive grains and a super-abrasive grinding wheel. This application claims priority based on Japanese Patent Application No. 2018-020958 filed on February 8, 2018. The entire contents of the description of the Japanese patent application are incorporated herein by reference.

### BACKGROUND ART

A super-abrasive tool (a wheel) of PTL 1 is known as a tool used for precision processing. This super-abrasive tool includes a disk-shaped substrate and an abrasive grain layer formed on an outer peripheral portion of the substrate. The abrasive grain layer includes super-abrasive grains (diamond abrasive grains, cubic boron nitride abrasive grains or the like) and a bonding material which bonds the super-abrasive grains and fixes the super-abrasive grains to the outer peripheral portion of the substrate.

### CITATION LIST

### PATENT LITERATURE

PTL 1: Japanese Patent Laying-Open No. 2002-137168

### SUMMARY OF INVENTION

According to the present disclosure, a super-abrasive grain comprises:
a body composed of cubic boron nitride or diamond; and
a ceramic coating film coating at least a portion of a surface of the body.

According to the present disclosure, a super-abrasive grinding wheel comprises:
a disk-shaped substrate; and
a super-abrasive grain layer covering at least an outer peripheral surface of the substrate,
the super-abrasive grain layer having super-abrasive grains according to the present disclosure.

### BRIEF DESCRIPTION OF DRAWINGS

Fig. 1 is a schematic cross section of a super-abrasive grain according to an embodiment.
Fig. 2 is an enlarged cross section of a portion of the super-abrasive grain shown in Fig. 1 that is surrounded by a circle drawn with a broken line.
Fig. 3 is a schematic perspective view of a super-abrasive grinding wheel according to an embodiment.
Fig. 4 is a cross section of the super-abrasive grinding wheel shown in Fig. 3 taken along a line (IV)-(IV).
Fig. 5 is an enlarged cross section of a portion of the super-abrasive grinding wheel shown in Fig. 4 that is surrounded by a circle drawn with a broken line.

### DETAILED DESCRIPTION

### [Problem to be Solved by the Present Disclosure]

The above super-abrasive grain layer includes super-abrasive grains that are per se (or their bodies are) bare abrasive grains and are thus susceptible to large stress from a workpiece. Therefore, the abrasive grains may be fractured or similarly damaged.

Accordingly, it is one object to provide a super-abrasive grain having a body which is not easily damaged.

Another object is to provide a super-abrasive grinding wheel having a high grinding ratio.

### [Advantageous Effect of the Present Disclosure]

The super-abrasive grain described above has a body which is not easily damaged.

The super-abrasive grinding wheel has a high grinding ratio.

### [Description of Embodiments]

Initially, embodiments of the present disclosure will be enumerated and specifically described.
(1) A super-abrasive grain in one aspect of the present disclosure comprises:
   a body composed of cubic boron nitride or diamond; and
   a ceramic coating film coating at least a portion of a surface of the body.
      According to the above configuration, the body of the abrasive grain is not easily damaged. This is because the coating film coating at least a portion of the surface of the body of the abrasive grain helps to alleviate an impactive force experienced by the body of the abrasive grain as it is brought into contact with a workpiece. Thus the body of the abrasive grain is not easily cracked and thus does not easily provide a fracture starting point, and in addition, if it should be cracked it is not easily further cracked. A grinding tool (grindstone) such as a super-abrasive grinding wheel having a high grinding ratio can thus be constructed. Note that a grinding ratio is "the volume of the workpiece ground away/the total worn volume of super-abrasive grains."
(2) As one form of the above super-abrasive grain,
   the body of the abrasive grain has a single-crystal structure.
   The above configuration helps to enhance the body per se of the abrasive grain in strength, as compared with an abrasive grain having a body having a polycrystalline structure.
(3) As one form of the above super-abrasive grain,
   the body of the abrasive grain has a polycrystalline structure.
   According to the above configuration, even when the abrasive grain has a body having a polycrystalline structure, including the coating film helps to provide a grinding ratio increased as compared with that provided in the case of an abrasive grain having a body having a single-crystal structure.
(4) As one form of the above super-abrasive grain,
   the coating film has an average crystal grain size of 500 nm or less.
   According to the above configuration, the coating film has a small average crystal grain size and hence large strength, and thus helps to suppress damage to the coating film per se that is caused by an impactive force (or stress) caused as the abrasive grain is brought into contact with a workpiece. This helps to alleviate impactive force exerted to the body of the abrasive grain as it is brought into contact with the workpiece.
(5) As one form of the above super-abrasive grain,
   the coating film has an average crystal grain size of 50 nm or less.
   According to the above configuration, the coating film has a further smaller average crystal grain size, and can further be enhanced in strength.
(6) As one form of the above super-abrasive grain,
   the coating film includes one selected from the following (a) and (b):
   (a) a nitride, a carbide, a carbonitride, an oxide, or an oxynitride containing one or more elements selected from group 4 elements, group 5 elements and group 6 elements in the periodic table, Al, Si, Y, Mg, and Ca; and
   (b) diamond-like carbon or diamond.
      According to the above configuration, the coating film is high in hardness and excellently wear-resistant, and thus helps to suppress damage to the body of the abrasive grain.
(7) As one form of the above super-abrasive grain,
   the coating film is composed of (Ti_{1-xb1-yb1}Si_{xb1}M1_{yb1})(C_{1-zb1}N_{zb1}) or (Al_{1-xb2}M_{2xb2})(C_{1-zb2}N_{zb2}).
   M1 = one or more elements selected from group 4 elements, group 5 elements and group 6 elements in the periodic table, and Al (Note that Ti is excluded),
   xb1 = 0 or more and 0.45 or less,
   yb1 = 0 or more and 0.5 or less,
   zb1 = 0.2 or more and 0.5 or less, and
   M2 = one or more elements selected from group 4 elements, group 5 elements and group 6 elements in the periodic table, and Si,
   xb2 = 0.025 or more and 0.475 or less,
   zb2 = 0.2 or more and 0.5 or less.
   The above configuration enables particularly excellent wear-resistance.
(8) As one form of the above super-abrasive grain, the coating film has a thickness of 1 nm or more and 5000 nm or less.
   When the coating film has a thickness of 1nm or more, it helps to enhance the coating film per se in strength and hence suppress damage to the coating film. This helps to suppress damage to the body of the abrasive grain. When the coating film has a thickness of 5000 nm or less, the coating film does not have an excessively large thickness and thus does not easily peel off, and a state with the coating film formed on an outer periphery of the body of the abrasive grain is easily maintained.
(9) As one form of the above super-abrasive grain, the coating film has a multilayer structure composed of a plurality of stacked ceramic layers.
   According to the above configuration, the multilayer structure allows each layer's residual stress to be increased, and thus allows the coating film to be high in hardness and helps to enhance an effect to suppress damage to the coating film.
(10) As one form of the above super-abrasive grain, it further comprises an insulating film covering an outer surface of the coating film.
   According to the above configuration, super-abrasive grains are easily fixed to an outer peripheral surface of a substrate of a super-abrasive grinding wheel through electroplating. That is, a plating film is easily used as a bonding material to fix super-abrasive grains to the outer peripheral surface of the substrate of the super-abrasive grinding wheel. This is because the insulating film does not allow the plating film to easily grow on a surface of the insulating film and excessive reduction of the grinding ratio can be suppressed by the plating film.
(11) As one form of the above super-abrasive grain, the insulating film includes a compound of any one of an oxide and an oxynitride containing one or more elements selected from Al, Si, Zr, and Ti.
   According to the above configuration, the insulating film has an excellent insulating property, and super-abrasive grains are easily fixed to the outer peripheral surface of the substrate of the super-abrasive grinding wheel through electroplating.
(12) As one form of the above super-abrasive grain, the insulating film has a thickness of 1 nm or more and 5000 nm or less.
   The insulating film having a thickness of 1 nm or more has its insulating performance easily enhanced. The insulating film having a thickness of 5000 nm or less is not excessively large in thickness and it does not easily peel off, and it is easy to maintain a state in which the insulating film is formed on the outer surface of the coating film.
(13) As one form of the above super-abrasive grain, the body of the abrasive grain has a grain size of 1 µm or more and 600 µm or less.
   The abrasive grain having a body with a grain size of 1 µm or more is not excessively small and thus facilitates grinding a workpiece and in addition, it is also easily handled and hence facilitates constructing a super-abrasive grinding wheel described hereinafter. The abrasive grain having a body with a grain size of 600 µm or less is not excessively large and thus not easily fractured or similarly damaged due to an impactive force exerted to the body of the abrasive grain as it is brought into contact with a workpiece.
(14) A super-abrasive grinding wheel in one aspect of the present disclosure comprises:
   a disk-shaped substrate; and
   a super-abrasive grain layer covering at least an outer peripheral surface of the substrate,
   the super-abrasive grain layer having the super-abrasive grain according to any one of items (1) to (13) above.

According to the above configuration, a super-abrasive grain having a body not easily damaged is comprised, and a high grinding ratio can be achieved.

### <<Detailed Description of Embodiments of the Present Disclosure>>

Details of embodiments of the present disclosure will be described below with reference to the drawings.

### [Super-abrasive grain]

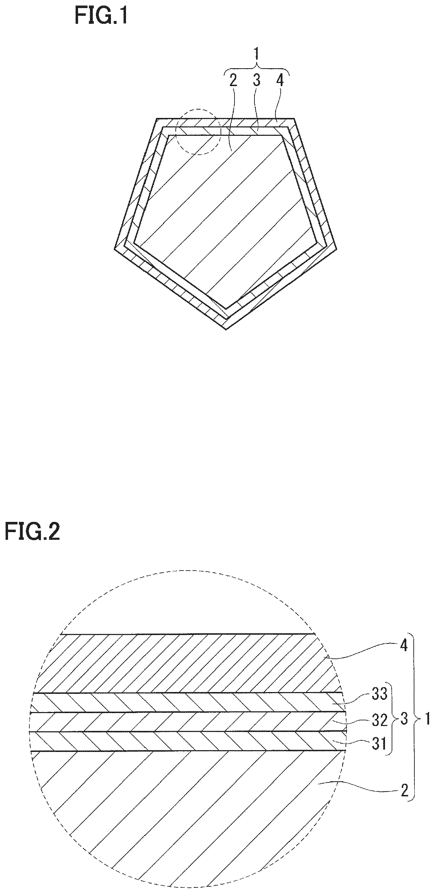

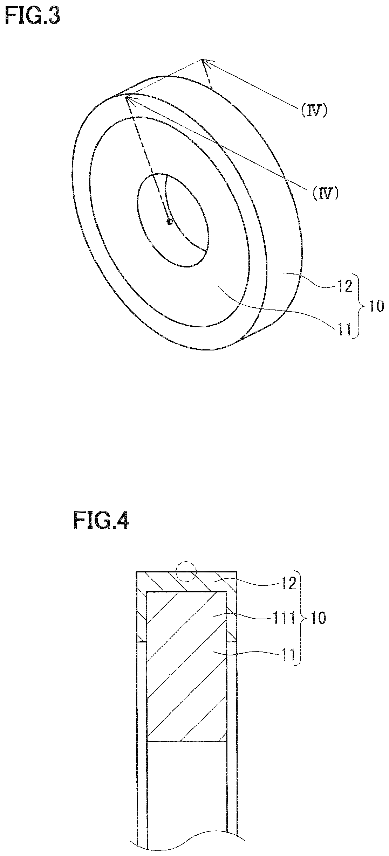

A super-abrasive grain 1 according to an embodiment will be described mainly with reference to Figs. 1 and 2 (and Fig. 3 to Fig. 5 where appropriate). Super-abrasive grain 1 is a member used to grind a workpiece, and includes a body 2 and a coating film 3 coating a surface of body 2 of the abrasive grain. One feature of super-abrasive grain 1 is that coating film 3 has a specific structure. Details will be described below.

### [Body of abrasive grain]

Body 2 of the abrasive grain is formed of cubic boron nitride (cBN) or diamond. Body 2 of the abrasive grain has a single-crystal or polycrystalline structure. Body 2 of the abrasive grain has a grain size preferably of 1 µm or more and 600 µm or less. Abrasive grain having body 2 with a grain size of 1 µm or more is not excessively small, and thus facilitates grinding a workpiece and in addition, it is also easily handled and hence facilitates constructing a super-abrasive grinding wheel 10 (see Figs. 3-5) and other similar grinding tools (or grindstone). An abrasive grain having body 2 with a grain size of 600 µm or less is not excessively large and thus not easily fractured or similarly damaged due to an impactive force (or stress) experienced by body 2 of the abrasive grain as it is brought into contact with a workpiece. Body 2 of the abrasive grain more preferably has a grain size of 10 µm or more and 300 µm or less, and particularly preferably 20 µm or more and 200 µm or less. When body 2 of the abrasive grain has a single-crystal structure, the grain size of body 2 of the abrasive grain can also be referred to as a crystal grain size. The grain size of body 2 of the abrasive grain is an average grain size when there are a plurality of abrasive grains 1, such as super-abrasive grinding wheel 10 described later has. When body 2 of the abrasive grain has a polycrystalline structure, the average crystal grain size is preferably 100 nm or more and 6000 nm or less, more preferably 200 nm or more and 4000 nm or less, and particularly preferably 300 nm or more and 2000 nm or less.

Compositional analysis can be performed by energy dispersive x-ray (EDS) analysis. Structural analysis can be performed by x-ray diffraction (for measurement of peak intensity) or scanning transmission electron microscopic (STEM) observation. The grain size of body 2 of the abrasive grain is determined by (average grain size of super-abrasive grains 1) - (thickness of coating film 3 + thickness of insulating film 4) × 2. The average grain size of super-abrasive grains 1 is measured with a laser diffraction type particle size distribution analyzer (for example, the SALD series manufactured by Shimadzu Corporation). The thickness of coating film 3 and that of insulating film 4 are measured in a measurement method described hereinafter. The average crystal grain size of bodies 2 of the abrasive grains is determined from cross sections of bodies 2 of the abrasive grains exposed by FIB (focused ion beam), as obtained from an HAADF (high-angle annular dark field)-STEM image obtained through an STEM (JEM-ARM200F Dual-X Nippon produced by JEOL Ltd.). From a difference in contrast of each crystal grain in the HAADF-STEM image, the cross-sectional area of each crystal grain is derived by image analysis software, and the diameter of a circle having an area equal to that cross-sectional area (or an equivalent circle diameter) is determined. An average value of the equivalent circle diameters of ten or more crystal grains is taken as the average crystal grain size of bodies 2 of the abrasive grains.

### [Coating film]

Coating film 3 coats at least a portion of the surface of body 2 of each abrasive grain and alleviates an impactive force (or stress) experienced by body 2 of the abrasive grain as it is brought into contact with the workpiece. Coating film 3 is formed to coat substantially the entire surface of body 2 of the abrasive grain in this example. By including coating film 3, body 2 of the abrasive grain is not easily cracked and thus does not easily provide a fracture starting point, and in addition, if it should be cracked it is not easily further cracked. Body 2 is thus not easily damaged, and super-abrasive grinding wheel 10 having a high grinding ratio can be constructed.

Note that a grinding ratio is "the volume of a workpiece ground away/the total worn volume of super-abrasive grains." The volume of the workpiece ground away is determined from the difference in volume between the workpiece before being ground and the workpiece after being ground. The super-abrasive grains' total worn volume is determined as follows: By grinding a carbon plate by the super-abrasive grinding wheel before and after a grinding process, undulations of an abrasive surface of the super-abrasive grinding wheel to which the super-abrasive grains are fixed are transferred to the carbon plate. When grinding the carbon plate, the super-abrasive grinding wheel is rotated to cut into the carbon plate without moving the carbon plate. The cross-sectional shape of the undulations of each carbon plate transferred before and after the grinding process is measured with a stylus type surface roughness meter in a direction perpendicular to a direction in which the super-abrasive grinding wheel rotates. Two cross-sectional shapes obtained before and after the grinding process are compared to determine the reduced area. Let "(the reduced area) × (the diameter of the super-abrasive grinding wheel)" be the total worn volume of super-abrasive grains 1. The removed amount in volume is determined by the product of the cutting depth and the length and thickness of the workpiece. Material's removed amount in volume is represented by a horizontal axis and a worn amount is represented by a vertical axis to plot a change, and therefrom a linear function of the change is determined by the method of least squares to calculate a gradient. This is used to calculate the super-abrasive grains' total worn volume for any removed amount in volume.

### (Material)

Coating film 3 is a ceramic coating film. Specific ceramics include one selected from the following (a) and (b). This allows body 2 not to be easily damaged. This is because coating film 3 of the following materials is high in hardness and excellently wear-resistant.

(a) a nitride, a carbide, a carbonitride, an oxide, or an oxynitride containing one or more elements selected from group 4 elements, group 5 elements and group 6 elements in the periodic table, aluminum (Al), silicon (Si), yttrium (Y), magnesium (Mg), and calcium (Ca), and (b) diamond-like carbon or diamond

The group 4 elements in the periodic table are titanium (Ti), zirconium (Zr) and hafnium (Hf). The group 5 elements in the periodic table are vanadium (V), niobium (Nb) and tantalum (Ta). The group 6 elements in the periodic table are chromium (Cr), molybdenum (Mo) and tungsten (W).

The ceramic's composition is particularly preferably (Ti_{1-xb1-yb1}Si_{xb1}Ml_{yb1})(C_{1-zb1}N_{zb1}), or (Al_{1-xb2}M2_{xb2})(C_{1-zb2}N_{zb2}). This helps to further suppress damage to body 2 of the abrasive grain. This is because coating film 3 satisfying these compositions is particularly excellently wear-resistant.
M1 = one or more elements selected from group 4 elements, group 5 elements and group 6 elements in the periodic table, and Al (Note that Ti is excluded),
xb1 = 0 or more and 0.45 or less,
yb1 = 0 or more and 0.5 or less,
zb1 = 0.2 or more and 0.5 or less, and
M2 = one or more elements selected from group 4 elements, group 5 elements and group 6 elements in the periodic table, and Si,
xb2 = 0.025 or more and 0.475 or less,
zb2 = 0.2 or more and 0.5 or less.

The nitride typically contains two of the above elements, and in addition, includes nitrides containing three of the above elements. Specifically, nitrides containing two of the above elements include nitrides containing: one element selected from Zr, Hf, V, Nb, Ta, Cr, Mo, W, Al, and Si; and Ti. More specifically, the nitrides containing two of the above elements include TiVN, TiCrN, TiZrN, TiNbN, TiMoN, TiHfN, TiTaN, TiWN, TiAIN, and TiSiN. Another nitride containing two of the above elements includes AlCrN. Specifically, the nitrides containing three of the above elements include nitrides containing: one element selected from Zr, Nb, Ta, and Si; Ti; and Al. More specifically, the nitrides containing three of the above elements include TiAlZrN, TiAlNbN, TiAlTaN, and TiAlSiN. Among these nitrides, TiAIN, AlCrN and TiAlSiN are particularly preferable. It is because they are particularly excellently wear resistant.

As the above carbide and the above carbonitride, as well as the above nitride, carbides and carbonitrides containing two of the above elements are representative. That is, carbides and carbonitrides containing: one element selected from Zr, Hf, V, Nb, Ta, Cr, Mo, W, Al and Si; and Ti can be referred to. More specifically, the above carbides include TiVC, TiCrC, TiZrC, TiNbC, TiMoC, TiHfC, TiTaC, TiWC, TiAlC, and TiSiC. More specifically, the above carbonitrides include TiVCN, TiCrCN, TiZrCN, TiNbCN, TiMoCN, TiHfCN, TiTaCN, TiWCN, TiAlCN, and TiSiCN.

Specifically, the above oxide includes oxides containing: one element selected from Ti, Cr, Zr, Hf, Ta, W, Al, and Si. More specifically, the above oxides include TiO₂, Cr₂O₃, ZrO₂, HfO₂, Ta₂O₅, WO₃, Al₂O₃, and SiO₂.

Specifically, the above oxynitride includes SiAlON.

Compositional analysis of coating film 3 can be performed by EDS analysis, similarly as done for the composition analysis of body 2 of the abrasive grain.

### (Structure and average grain size)

The structure of coating film 3 is, for example, a polycrystalline structure. It is preferable that coating film 3 has an average crystal grain size of 500 nm or less. Coating film 3 thus having a small average crystal grain size can be high in strength. This facilitates suppressing damage to coating film 3 itself that is caused by impactive force (or stress) caused as the abrasive grain is brought into contact with a workpiece, and in addition, also facilitates alleviating an impactive force experienced by body 2 of the abrasive grain as it is brought into contact with the workpiece. Body 2 is thus not easily damaged. The smaller the average crystal grain size of coating film 3 is, the higher the strength of coating film 3 itself can be, and 200 nm or less is preferable, and 50 nm or less is particularly preferable. The average crystal grain size of coating film 3 is preferably 1 nm or more.

The average crystal grain size of coating film 3 is determined from a HAADF-STEM image through STEM. In observing a HAADF-STEM image of the coating film, when coating film 3 has a thickness of 100 nm or more, coating film 3 is mechanically polished and subjected to Ar-ion milling to have a thickness of 100 nm or less. The STEM's magnification is set to 6.5 million times and thus used to observe the HAADF-STEM image of coating film 3 in ten or more areas in which an atomic arrangement can be observed. One area where the atomic arrangement can be observed is taken as one crystal grain. In a HAADF-STEM image, a crystal grain different in crystal orientation is unobservable, and an area where an atomic arrangement is observed can be regarded as a crystal grain. An average grain size of the ten or more crystal grains is taken as an average crystal grain size of coating film 3. In doing so, an equivalent circle diameter of one area where the atomic arrangement can be observed is taken as one crystal grain size.

### (Structure)

Coating film 3 may have a monolayer structure composed of the above ceramics, or may be a multilayer structure (see Fig. 2) in which a plurality of layers composed of the above ceramics are stacked. Coating film 3 having a multilayer structure allows each layer's residual stress to be increased as compared with the coating film having a monolayer structure, and can thus be high in hardness and thus resistant to damage thereto. This helps to suppress damage to body 2 of the abrasive grain. When coating film 3 has a multilayer structure, it may have two or three layers for example. In that case, adjacent layers may be formed of different ceramics. For example, when coating film 3 has a three-layer structure (see Fig. 2), with a first layer 31 to a third layer 33 disposed sequentially from the side of body 2 of the abrasive grain outwards, with second layer 32 composed of a material different from that of first layer 31 and that of third layer 33, first layer 31 and third layer 33 may be composed of identical materials or different materials (that is, the three layers may be composed respectively of different materials). The structure of coating film 3 can be analyzed through a cross-sectional observation with an STEM.

### (Thickness)

Coating film 3 preferably has a thickness of 1 nm or more and 5000 nm or less. When coating film 3 has a thickness of 1nm or more, it helps to enhance coating film 3 per se in strength and hence suppress damage to coating film 3. When coating film 3 has a thickness of 5000 nm or less, coating film 3 does not have an excessively large thickness and thus does not easily peel off, and a state with coating film 3 formed on an outer periphery of body 2 of the abrasive grain is easily maintained. The thickness of coating film 3 is more preferably 10 nm or more and 2500 nm or less, and particularly preferably 100 nm or more and 1000 nm or less. When coating film 3 has a multilayer structure as described above, the thickness of coating film 3 is the sum of each layer in thickness. When coating film 3 has a multilayer structure, each layer may be similar or different in thickness.

The thickness of coating film 3 is determined by " { (equivalent circular diameter of super-abrasive grain 1) - (equivalent circular diameter of body 2 of the abrasive grain)}/2." The equivalent circle diameter of super-abrasive grain 1 and that of body 2 of the abrasive grain are determined as follows: in a cross section of super-abrasive grain 1, super-abrasive grain 1 and body 2 of the abrasive grain have their respective contours determined, and a diameter of a circle having the same area as an area S surrounded by each contour is determined as the equivalent circular diameter. That is, the equivalent circular diameter is represented as 2 x {area S inside the contour/π}^{1/2}. For a plurality of super-abrasive grains 1, the equivalent circle diameter of super-abrasive grains 1 and that of bodies 2 of the abrasive grains are each an average of equivalent circle diameters obtained from 30 or more super-abrasive grains 1 in cross section.

The cross section of super-abrasive grain 1 is exposed as follows: A molded body in which super-abrasive grains 1 are buried in epoxy resin is produced. The content of super-abrasive grains 1 in the molded body is 50% by volume or more with respect to the resin. The shape of the molded body is a rectangular parallelepiped or a cube. The molded body is subjected to a CP (cross section polisher) process. This process is performed in two stages. In a first stage of the process, the molded body has any surface processed until a cross section of at least one super-abrasive grain 1 is visible. Once the cross section of super-abrasive grain 1 has been confirmed, then, as a second stage of the process, the surface is further processed by 50% of the average grain size of super-abrasive grains 1. The average grain size of super-abrasive grains 1 is a value as measured with a laser diffraction type particle size distribution analyzer, as has been described above.

The cross section of the molded body is observed, and an equivalent circle diameter of super-abrasive grain 1 and that of body 2 of the abrasive grain are determined. The cross-sectional observation is performed using a scanning electron microscope (SEM), energy dispersive x-ray analysis (EDX), electron backscatter diffraction (EBSD) analysis, or the like. Body 2 of the abrasive grain, coating film 3 and the resin portion are separated through an image analyzing binarization process. From an image obtained therefrom, the area in cross section of super-abrasive grain 1 and that of body 2 of the abrasive grain are derived and the equivalent circle diameter of super-abrasive grain 1 and that of body 2 of the abrasive grain are determined.

### (Coating method)

While coating film 3 is formed on the surface of body 2 of the abrasive grain by physical vapor deposition such as an arc ion plating (AIP) method, a HIPIMS (High Power Impulse Magnetron Sputtering) method, an arc plasma powder method or the like, it is optimally formed for example in the arc plasma powder method. The coating is applied under conditions including a discharge voltage of 10 V or more and 200 V or less, a discharge frequency of 1 Hz or more and 20 Hz or less, a capacitor having a capacitance of 360 µF or more and 1800 µF or less, a shot count of 1000 or more and 10,000,000 or less, and a heat treatment temperature of 100°C or higher and 2000°C or lower. In particular, lower heat treatment temperature facilitates forming a coating film having a small average crystal grain size. For example, a heat treatment temperature of 1000°C or lower helps to provide a coating film having an average crystal grain size of 500 nm or less, and a heat treatment temperature of 200°C or lower helps to provide a coating film having an average crystal grain size of 50 nm or less. The coating film is easily reduced in thickness by reducing a period of time of coating, and a coating time of 150 hrs or less (for bodies 2 having a mass of 10 g) allows the coating film to have a thickness of 1 nm or more and 5000 nm or less.

### [Insulating film]

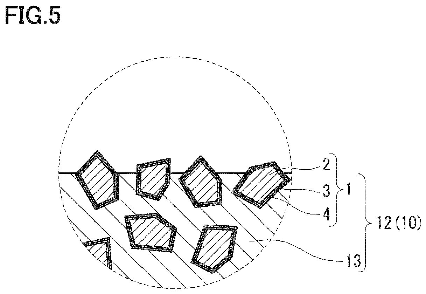

Super-abrasive grain 1 may further include an insulating film 4 covering an outer surface of coating film 3 (see Figs. 1 and 2). This facilitates fixing super-abrasive grains 1 to an outer peripheral surface 111 (see Fig. 4) of a substrate 11 of super-abrasive grinding wheel 10 (see Fig. 3 and Fig. 4) through electroplating. That is, it facilitates using a plating film as a bonding material 13 (see Fig. 5) for fixing super-abrasive grains 1 on outer peripheral surface 111 of substrate 11. This is because insulating film 4 does not allow the plating film to easily grow on a surface of insulating film 4 and excessive reduction of the grinding ratio can be suppressed by the plating film.

### (Material)

Insulating film 4 is preferably formed of a material including a compound of an oxide or oxynitride containing one or more elements selected from Al, Si, Zr, and Ti. These materials are excellently insulating, and super-abrasive grains 1 are easily fixed to outer peripheral surface 111 (see Fig. 4) of substrate 11 of super-abrasive grinding wheel 10 through electroplating. Specifically, insulating film 4 is formed of material including, Al₂O₃, ZrO₂, SiAlON, and the like. A compositional analysis of insulating film 4 can be performed by EDS analysis, similarly as done for the compositional analysis of coating film 3.

### (Thickness)

Insulating film 4 preferably has a thickness of 1 nm or more and 5000 nm or less. When insulating film 4 has a thickness of 1 nm or more, it helps to enhance insulation. Insulating film 4 having a thickness of 5000 nm or less is not excessively large in thickness and it does not easily peel off, and it is easy to maintain a state in which insulating film 4 is formed on the outer surface of coating film 3. The thickness of insulating film 4 is more preferably 100 nm or more and 2000 nm or less, and particularly preferably 200 nm or more and 1000 nm or less.

When insulating film 4 is provided, the thickness of coating film 3 of super-abrasive grain 1 is determined by {(equivalent circle diameter of outer periphery of coating film 3) - (equivalent circle diameter of body 2 of the abrasive grain)}/2, and the thickness of insulating film 4 of super-abrasive grain 1 is determined by {(equivalent circle diameter of super-abrasive grain 1) - (equivalent circle diameter of outer periphery of coating film 3)}/2. How the equivalent circle diameter of super-abrasive grain 1 and the equivalent circle diameter of body 2 of the abrasive grain are determined is as has been described above. The equivalent circle diameter of the outer periphery of coating film 3 is the equivalent circle diameter of a boundary portion between coating film 3 and insulating film 4 and let it be a diameter of a circle having the same area as a total cross sectional area of coating film 3 and body 2 of the abrasive grain. A transparent sheet is placed on the image of the cross section, and the observer traces an interface between coating film 3 and insulating film 4 and fills in only the area inside the interface (i.e., the area of coating film 3 and body 2 of the abrasive grain) with black. Image analysis software is used to subject the black portion and the white portion to binarization to divide the image and a total cross-sectional area of coating film 3 and body 2 of the abrasive grain is derived therefrom. The diameter of a circle having the same area as the total cross-sectional area is determined, and the equivalent circle diameter of the outer periphery of coating film 3 is determined. The interface between coating film 3 and insulating film 4 can also be extracted by image analysis software from a difference in contrast between coating film 3 and insulating film 4 or the like.

### (Covering method)

Insulating film 4 can be formed by the arc plasma powder method, similarly as done to form coating film 3.

### [Application]

Super-abrasive grain 1 according to an embodiment is suitably applicable as abrasive grains for a grinding tool (grindstone), such as a super-abrasive grinding wheel.

### [Function and Effect]

Super-abrasive grain 1 according to the embodiment has coating film 3 large in strength coating the surface of body 2 of the abrasive grain and thus does not easily transmit to body 2 of the abrasive grain an impactive force caused as the abrasive grain is brought into contact with a workpiece, and thus body 2 is not easily damaged. A grindstone having a high grinding ratio can thus be constructed.

### [Super-abrasive grinding wheel]

Super-abrasive grinding wheel 10 according to an embodiment will be described mainly with reference to Figs. 3 to 5. Super-abrasive grinding wheel 10 includes a disk-shaped substrate 11 and a super-abrasive grain layer 12 covering an outer peripheral surface 111 (see Fig. 4) of substrate 11.

### [Substrate]

Substrate 11 is formed of material including Al and an Al alloy, iron and an iron alloy, carbon tool steel, high speed tool steel, alloy tool steel, cemented carbide, cermet and the like. Substrate 11 can have a size (inner and outer diameters and thickness) selectable as appropriate depending for example on the size of a machine tool such as a machining center on which super-abrasive grinding wheel 10 is installed, that is, depending on the size of the workpiece. Substrate 11 can be a substrate for a known super-abrasive grinding wheel.

### [Super-abrasive grain layer]

Super-abrasive grain layer 12 in this example is formed to cover front and back and outer peripheral end surfaces of outer peripheral surface 111 of substrate 11 continuously (see Figs. 3 and 4). Super-abrasive grain layer 12 can be selected in size (thickness and width), as appropriate, depending on the size (thickness and width) of substrate 11. The thickness refers to a length in the axial direction of super-abrasive grinding wheel 10, and the width refers to a length in the radial direction of super-abrasive grinding wheel 10. Super-abrasive grain layer 12 includes super-abrasive grains 1 and bonding material 13 (see Fig. 5).

### (Super-abrasive grain)

Super-abrasive grain 1 is as has been discussed above. There may be provided a plurality of super-abrasive grains 1. Super-abrasive grain layer 12 on the side of its front surface has super-abrasive grains 1 partially exposed from bonding material 13 to provide a cutting edge portion for grinding a workpiece. In contrast, super-abrasive grain layer 12 on the side of substrate 11 has super-abrasive grains 1 all buried in bonding material 13. Super-abrasive grains 1 that are buried are partially exposed and thus grind the workpiece during a process in which while the workpiece is ground by super-abrasive grinding wheel 10 super-abrasive grains 1 on the side of the front surface of super-abrasive grain layer 12 are worn and fall off and bonding material 13 are also worn. The plurality of super-abrasive grains 1 may have their respective bodies 2 identically configured (i.e., identical in material, equal in size and the like) and their respective coating films 3 identically configured (i.e., identical in material, equal in thickness and the like), or some super-abrasive grains 1 may have body 2 and coating film 3 different in configuration (i.e., material, size, and the like) than other super-abrasive grains 1. For example, some super-abrasive grains 1 may have their bodies 2 composed of cBN and other super-abrasive grains 1 may have their bodies 2 composed of diamond, and some and other super-abrasive grains 1 may have their respective coating films 3 identically configured (i.e., identical in material, and equal in thickness and grain size).

The average grain size of super-abrasive grains 1 is determined by dissolving bonding material 13 of super-abrasive grain layer 12 with acid or the like to remove super-abrasive grains 1 and measuring the removed super-abrasive grains 1 with a laser diffraction type particle size distribution analyzer. When super-abrasive grain layer 12 is large, super-abrasive grain layer 12 is cut off by a predetermined volume (for example of 0.5 cm³), and from the cut portion, super-abrasive grains 1 are removed by dissolving bonding material 13. The average grain size of bodies 2 of the abrasive grains are determined as follows: super-abrasive grains 1 have coating film 3, insulating film 4 and the like dissolved together with bonding material 13 to have their bodies 2 alone removed therefrom and measured with a laser diffraction type particle size distribution analyzer. Alternatively, coating film 3 and insulating film 4 are not dissolved and bonding material 13 is alone dissolved to remove super-abrasive grains 1 and the average grain size of bodies 2 may be determined by "(average grain size of super-abrasive grains 1) - (thickness of coating film 3 + thickness of insulating film 4) × 2," as has been set forth above.

### (Bonding material)

Bonding material 13 fixes super-abrasive grains 1 to outer peripheral surface 111 (Fig. 4). Bonding material 13 includes in type one type selected from resin bond, metal bond, vitrified bond, electroplating bond and a combination thereof, or metal wax, for example. As these bonds and metal wax can be known bonds and metal wax. For example, the resin bond includes as a main component a thermosetting resin such as phenol resin, epoxy resin, and polyimide resin. The metal bond includes as a main component an alloy containing copper, tin, iron, cobalt, or nickel. The vitrified bond may include a vitreous material as a main component. The electroplating bond includes nickel plating. The metal wax includes silver (Ag) wax and the like. The type of bonding material 13 can be appropriately selected depending on what material coating film 3 of super-abrasive grain 1 is made of, whether insulating film 4 is present or absent, and the like. For example, when coating film 3 of super-abrasive grain 1 is electrically conductive but does not have insulating film 4, then, as bonding material 13, electroplating bond is excluded and resin bond, metal bond, vitrified bond, and metal wax can be used. When coating film 3 of super-abrasive grain 1 has an insulating property or has insulating film 4 regardless of what material coating film 3 is made of, all the above bonds including electroplating bond and metal wax can be used.

Super-abrasive grinding wheel 10 (see Fig. 3) can be produced as follows: a plurality of super-abrasive grains 1 each having body 2 having a surface at least partially coated with coating film 3 (see Fig. 1) are prepared and fixed to outer peripheral surface 111 of substrate 11 by using bonding material 13 (see Fig. 5). Alternatively, super-abrasive grinding wheel 10 may be produced as follows: a plurality of bodies 2 for abrasive grains uncoated with coating film 3 are prepared and fixed to outer peripheral surface 111 of substrate 11 by using bonding material 13, and thereafter, bodies 2 have their surfaces (or cutting edge portion) coated with coating film 3. In that case, the coating can be done in any of the AIP method, HIPIMS method, and arc plasma powder method mentioned above.

### [Application]

Super-abrasive grinding wheel 10 according to an embodiment is suitably applicable to grinding automobile parts, optical glass, magnetic materials, semiconductor materials, and the like, grinding to form grooves for end mills, drills and reamers and the like, grinding to form a breaker for an indexable insert, and heavy duty grinding for various tools.

### [Function and Effect]

Super-abrasive grinding wheel 10 according to an embodiment includes super-abrasive grain 1 with body 2 not easily damaged, and thus has a high grinding ratio.

### <<Test Example 1>>

Difference in grinding performance due to different crystal grain sizes of coating films of super-abrasive grains was evaluated.

### [Sample Nos. 1-1 to 1-9]

Sample Nos. 1-1 to 1-9 each provided a super-abrasive grain composed of a body and a coating film coating the body's entire surface. In the present example, the coating film had an external side without any insulating film formed thereon. This super-abrasive grain was produced by coating its body's surface with the coating film. As the body of the abrasive grain, single-crystal cubic boron nitride having an average grain size of 70 µm was used. The coating film was applied in the arc plasma powder method. The coating was done with a coating apparatus under conditions, as follows:
Coating apparatus: nanoparticle formation apparatus APD-P produced by ADVANCE RIKO, Inc.
Target: 50 atomic% of Ti and 50 atomic% of Al
Introduced gas: N₂
Deposition pressure: 0.88 Pa
Discharge voltage: 150 V
Discharge frequency: 6 Hz
Capacitor's capacitance: 1080 µF
Shot count: 800,000
Amount of powder processed: 30 g
Speed of rotation of powder container: 50 rpm

Each coating film's composition (atomic %), average crystal grain size (nm), and average thickness (nm) are shown in Table 1. Each coating film was applied through a variety of types of devices and subsequently a typical vacuum heat treatment furnace (NRF-658-0.7D1.5 V type produced by Nihon-tokusyukikai, with 1 x 10⁻³ Pa or less applied) was used to subject it to a heat treatment varied in temperature as shown in table 1 to provide a different average crystal grain size. Each coating film was subjected to a compositional analysis by EDS analysis.

Each coating film's average crystal grain size was determined from an HAADF-STEM image obtained through an STEM (JEM-ARM200F Dual-X produced by JEOL Ltd.). In observing the HAADF-STEM image of each coating film, the coating film was mechanically polished and subjected to Ar-ion milling (Dual Mill 600 produced by GATAN) to have a thickness of 100 nm or less. Then, an acceleration voltage of 200 kV was applied and a magnification of 6.5 million times was set to observe the HAADF-STEM image of the coating film in 10 areas in which an atomic arrangement was observable. One area in which the atomic arrangement was observable was regarded as one crystal grain, and such 10 crystal grains' average crystal grain size was regarded as the coating film's average crystal grain size. The equivalent circle diameter of one area in which the atomic arrangement was observable was regarded as one crystal grain size.

Each coating film's average thickness was determined by " { (equivalent circle diameter of super-abrasive grain) - (equivalent circle diameter of body of abrasive grain)}/2." The equivalent circle diameter of the super-abrasive grain and that of the body thereof were each an average of equivalent circle diameters obtained from 30 or more super-abrasive grains in cross section. The cross section of each super-abrasive grain was exposed as follows: A molded body in which super-abrasive grains were buried in epoxy resin was produced. The content of the super-abrasive grains in the molded body was set to 50% by volume or more with respect to the resin. The shape of the molded body was a rectangular parallelepiped or a cube. The molded body was subjected to a CP (cross section polisher) process. This process was performed in two stages. In a first stage of the process, the molded body had any surface processed until a cross section of at least one super-abrasive grain was visible. Once the cross section of the super-abrasive grain had been confirmed, then, as a second stage of the process, the surface was further processed by 50% of the average grain size of super-abrasive grains. The average grain size of super-abrasive grains was set to a value as measured with a laser diffraction type particle size distribution analyzer. The cross section of the molded body was observed, and an equivalent circle diameter of each super-abrasive grain and that of the body of the abrasive grain are determined. The super-abrasive grains' bodies and coating films and the resin portion underwent an image analyzing binarization process and thus separated to obtain an image, from which the super-abrasive grains' cross sections and their bodies' cross sections were derived and the super-abrasive grains' equivalent circular diameters and their bodies' equivalent circular diameters were determined and averaged.

The super-abrasive grains were used to produce a super-abrasive grinding wheel similar to super-abrasive grinding wheel 10 described with reference to Figs. 3 to 5, comprising a disk-shaped substrate and a super-abrasive grain layer covering at least an outer peripheral surface of the substrate. The super-abrasive grinding wheel was produced using each sample by fixing a plurality of super-abrasive grains to the outer peripheral surface of the substrate with a bonding material. Herein, the substrate was made of S45C, and had a diameter (an outer diameter): 50 mm, a mounting hole diameter (an inner diameter): 20 mm, and a thickness: 8 mm. The bonding material was an Ag wax material.

### [Evaluation of grinding performance]

The super-abrasive grinding wheel of each sample had its grinding performance evaluated by determining its grinding ratio. The grinding ratio was determined as follows: the super-abrasive grinding wheel of each sample was set in the following apparatus and ground a workpiece for 180 minutes under the following conditions, and the grinding ratio was determined from "the volume of the workpiece ground away/the total worn volume of super-abrasive grains." That is, the higher the grinding ratio, the better the grinding performance. The obtained grinding ratios are shown in Table 1.
Workpiece: SCM 415 hardened steel (3.5 mm x 60 mm x 100 mm)
Apparatus: Machining Center V-55 produced by Makino
Grinding wheel's peripheral speed: 2700 mm/min
Cutting: 1.2 mm
Feed rate: 50 mm/min
Coolant: Emulsion type (YUSHIROKEN®)

### [Sample No. 101]

Sample No. 101 was prepared to be similar to sample No. 1-1 except that the super-abrasive grain was composed of a body alone, that is, it did not include the coating film, and the samples were evaluated in grinding performance. A result thereof is shown in Table 1.

### [Sample Nos. 1-11 to 1-19 and 102]

As shown in table 2, Sample Nos. 1-11 to 1-19 and 102 were prepared to be similar to Sample Nos. 1-1 to 1-9 and 101, except that the super-abrasive grain had a body having a polycrystalline structure (with an average crystal grain size of 1000 nm), and the samples were evaluated in grinding performance. A result thereof is shown in table 2.

### [Sample Nos. 1-21 to 1-29 and 103]

As shown in table 3, Sample Nos. 1-21 to 1-29 and 103 were prepared to be similar to Sample Nos. 1-1 to 1-9 and 101, except that the super-abrasive grain had a body of single-crystal diamond and that the workpiece was commercially available Inconel® 718, and the samples were evaluated in grinding performance. A result thereof is shown in Table 3.

### [Sample Nos. 1-31 to 1-39 and 104]

As shown in table 4, Sample Nos. 1-31 to 1-39 and 104 were prepared to be similar to Sample Nos. 1-1 to 1-9 and 101, except that the super-abrasive grain had a body of diamond of polycrystal (with an average crystal grain size of 1000 nm) and that the workpiece was commercially available Inconel® 718, and the samples were evaluated in grinding performance. A result thereof is shown in table 4.

**Table 1**

| sample nos. | coating condition | coating film | | | | | | | | | | | | | | | | grinding ratio |
|---|---|---|---|---|---|---|---|---|---|---|---|---|---|---|---|---|---|---|
| | | composition (atomic %) | | | | | | | | | | | | | | average crystal grain size (nm) | average thickness (nm) | |
| | heat treatment temperature (°C) | Ti | V | Cr | Zr | Nb | Mo | Hf | Ta | W | Al | Si | C | N | O | | | |
| 1-1 | 1200 | 25 | - | - | - | - | - | - | - | - | 25 | - | - | 50 | - | 400 | 400 | 1401 |
| 1-2 | 1150 | 25 | - | - | - | - | - | - | - | - | 25 | - | - | 50 | - | 100 | 400 | 1430 |
| 1-3 | 1100 | 25 | - | - | - | - | - | - | - | - | 25 | - | - | 50 | - | 60 | 400 | 1494 |
| 1-4 | 1000 | 25 | - | - | - | - | - | - | - | - | 25 | - | - | 50 | - | 40 | 400 | 1502 |
| 1-5 | 900 | 25 | - | - | - | - | - | - | - | - | 25 | - | - | 50 | - | 20 | 400 | 1533 |
| 1-6 | 800 | 25 | - | - | - | - | - | - | - | - | 25 | - | - | 50 | - | 7 | 400 | 1635 |
| 1-7 | 600 | 25 | - | - | - | - | - | - | - | - | 25 | - | - | 50 | - | 3 | 400 | 1650 |
| 1-8 | 300 | 25 | - | - | - | - | - | - | - | - | 25 | - | - | 50 | - | 1 | 400 | 1750 |
| 1-9 | 1250 | 25 | - | - | - | - | - | - | - | - | 25 | - | - | 50 | - | 600 | 400 | 1200 |
| 101 | - | - | - | - | - | - | - | - | - | - | - | - | - | - | - | - | - | 1100 |

**Table 2**

| sample nos. | coating condition | coating film | | | | | | | | | | | | | | | | grinding ratio |
|---|---|---|---|---|---|---|---|---|---|---|---|---|---|---|---|---|---|---|
| | | composition (atomic %) | | | | | | | | | | | | | | average crystal grain size (nm) | average thickness (nm) | |
| | heat treatment temperature (°C) | Ti | V | Cr | Zr | Nb | Mo | Hf | Ta | W | Al | Si | C | N | O | | | |
| 1-11 | 1200 | 25 | - | - | - | - | - | - | - | - | 25 | - | - | 50 | - | 400 | 400 | 1611 |
| 1-12 | 1150 | 25 | - | - | - | - | - | - | - | - | 25 | - | - | 50 | - | 100 | 400 | 1645 |
| 1-13 | 1100 | 25 | - | - | - | - | - | - | - | - | 25 | - | - | 50 | - | 60 | 400 | 1718 |
| 1-14 | 1000 | 25 | - | - | - | - | - | - | - | - | 25 | - | - | 50 | - | 40 | 400 | 1727 |
| 1-15 | 900 | 25 | - | - | - | - | - | - | - | - | 25 | - | - | 50 | - | 20 | 400 | 1763 |
| 1-16 | 800 | 25 | - | - | - | - | - | - | - | - | 25 | - | - | 50 | - | 7 | 400 | 1880 |
| 1-17 | 600 | 25 | - | - | - | - | - | - | - | - | 25 | - | - | 50 | - | 3 | 400 | 1898 |
| 1-18 | 300 | 25 | - | - | - | - | - | - | - | - | 25 | - | - | 50 | - | 1 | 400 | 2013 |
| 1-19 | 1250 | 25 | - | - | - | - | - | - | - | - | 25 | - | - | 50 | - | 600 | 400 | 1380 |
| 102 | - | - | - | - | - | - | - | - | - | - | - | - | - | - | - | - | - | 1265 |

**[Table 3]**

| sample nos. | coating condition | coating film | | | | | | | | | | | | | | | | grinding ratio |
|---|---|---|---|---|---|---|---|---|---|---|---|---|---|---|---|---|---|---|
| | | composition (atomic %) | | | | | | | | | | | | | | average crystal grain size (nm) | average thickness (nm) | |
| | heat treatment temperature (°C) | Ti | V | Cr | Zr | Nb | Mo | Hf | Ta | W | Al | Si | C | N | O | | | |
| 1-21 | 1200 | 25 | - | - | - | - | - | - | - | - | 25 | - | - | 50 | - | 400 | 400 | 1155 |
| 1-22 | 1150 | 25 | - | - | - | - | - | - | - | - | 25 | - | - | 50 | - | 100 | 400 | 1179 |
| 1-23 | 1100 | 25 | - | - | - | - | - | - | - | - | 25 | - | - | 50 | - | 60 | 400 | 1232 |
| 1-24 | 1000 | 25 | - | - | - | - | - | - | - | - | 25 | - | - | 50 | - | 40 | 400 | 1238 |
| 1-25 | 900 | 25 | - | - | - | - | - | - | - | - | 25 | - | - | 50 | - | 20 | 400 | 1264 |
| 1-26 | 800 | 25 | - | - | - | - | - | - | - | - | 25 | - | - | 50 | - | 7 | 400 | 1348 |
| 1-27 | 600 | 25 | - | - | - | - | - | - | - | - | 25 | - | - | 50 | - | 3 | 400 | 1360 |
| 1-28 | 300 | 25 | - | - | - | - | - | - | - | - | 25 | - | - | 50 | - | 1 | 400 | 1443 |
| 1-29 | 1250 | 25 | - | - | - | - | - | - | - | - | 25 | - | - | 50 | - | 600 | 400 | 989 |
| 103 | - | - | - | - | - | - | - | - | - | - | - | - | - | - | - | - | - | 770 |

**[Table 4]**

| sample nos. | coating condition | coating film | | | | | | | | | | | | | | | | grinding ratio |
|---|---|---|---|---|---|---|---|---|---|---|---|---|---|---|---|---|---|---|
| | | composition (atomic %) | | | | | | | | | | | | | | average crystal grain size (nm) | average thickness (nm) | |
| | heat treatment temperature (°C) | Ti | V | Cr | Zr | Nb | Mo | Hf | Ta | W | Al | Si | C | N | O | | | |
| 1-31 | 1200 | 25 | - | - | - | - | - | - | - | - | 25 | - | - | 50 | - | 400 | 400 | 1160 |
| 1-32 | 1150 | 25 | - | - | - | - | - | - | - | - | 25 | - | - | 50 | - | 100 | 400 | 1184 |
| 1-33 | 1100 | 25 | - | - | - | - | - | - | - | - | 25 | - | - | 50 | - | 60 | 400 | 1237 |
| 1-34 | 1000 | 25 | - | - | - | - | - | - | - | - | 25 | - | - | 50 | - | 40 | 400 | 1243 |
| 1-35 | 900 | 25 | - | - | - | - | - | - | - | - | 25 | - | - | 50 | - | 20 | 400 | 1269 |
| 1-36 | 800 | 25 | - | - | - | - | - | - | - | - | 25 | - | - | 50 | - | 7 | 400 | 1353 |
| 1-37 | 600 | 25 | - | - | - | - | - | - | - | - | 25 | - | - | 50 | - | 3 | 400 | 1365 |
| 1-38 | 300 | 25 | - | - | - | - | - | - | - | - | 25 | - | - | 50 | - | 1 | 400 | 1448 |
| 1-39 | 1250 | 25 | - | - | - | - | - | - | - | - | 25 | - | - | 50 | - | 600 | 400 | 994 |
| 104 | - | - | - | - | - | - | - | - | - | - | - | - | - | - | - | - | - | 775 |

As shown in Table 1, Sample Nos. 1-1 to 1-9 including a coating film coating the surface of the body of the abrasive grain all presented a grinding ratio of 1200 or more, and it can be seen that the grinding ratio is higher than that of sample No. 101 that does not include the coating film. Furthermore, Sample Nos. 1-1 to 1-8 having a coating film with a crystal grain size of 400 nm or less all presented a grinding ratio of 1400 or more, Sample Nos. 1-2 to 1-8 having a coating film with a crystal grain size of 200 nm or less presented a grinding ratio of 1430 or more, Sample Nos. 1-4 to 1-8 having a coating film with a crystal grain size of 50 nm or less presented a grinding ratio of 1500 or more, Sample Nos. 1-6 to 1-8 having a coating film with a crystal grain size of 10 nm or less presented a grinding ratio of 1600 or more, and Sample No. 1-8 having a coating film with a crystal grain size of 1 nm presented a grinding ratio of 1700 or more. That is, it can be seen that the smaller a coating film is in crystal grain size, the higher a grinding ratio is.

As shown in Table 2, even when polycrystalline cubic boron nitride was used for the body of the abrasive grain, Sample Nos. 1-11 to 1-19 including the coating film all presented a grinding ratio of 1300 or more, and it can be seen that it is higher than that of sample No. 102 that does not include the coating film. As shown in Table 3, even when single-crystal diamond was used for the body of the abrasive grain, Sample Nos. 1-21 to 1-29 including the coating film all presented a grinding ratio of 950 or more, and it can be seen that it is higher than that of sample No. 103 that does not include the coating film. As shown in Table 4, even when polycrystalline diamond was used for the body of the abrasive grain, Sample Nos. 1-31 to 1-39 including the coating film all presented a grinding ratio of 990 or more, and it can be seen that it is higher than that of sample No. 104 that does not include the coating film. As shown in Tables 2 to 4, it can be seen that each sample having a coating film with a crystal grain size of 400 nm or less presents a high grinding ratio, and furthermore, samples having coating films with crystal grain sizes of 200 nm or less, 50 nm or less, particularly 10 nm or less, 1 nm present high grinding ratios. That is, it can be seen that, as well as Sample Nos. 1-1 to 1-9, Sample Nos. 1-11 to 1-19, 1-21 to 1-29, and 1-31 to 1-39 present higher grinding ratios for smaller crystal grain sizes of the coating film.

### <<Test Example 2>>

Difference in grinding performance due to different compositions of coating films of super-abrasive grains was evaluated.

### [Sample No.2 type samples, sample No.3 type samples, sample No.4 type samples, sample No. 5 type samples, sample No.6 type samples]

As shown in Tables 5-9, Sample No. 2 type samples to Sample No. 6 type samples had their super-abrasive grains with their coating films made different in composition and were evaluated in grinding performance, similarly as done for Sample No. 1-1. The coating films were made different in composition by variously changing the type of the target in the coating apparatus and the atmosphere in the apparatus. A shot count of 200,000 was set. Resultant grinding ratios of Sample No. 2 type samples to Sample No. 6 type samples are shown in Tables 5-9, respectively.

**[Table 5]**

| sample nos. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 2-1 | 25 | 25 | - | - | - | - | - | - | - | - | - | - | 50 | - | 3 | 100 | 1540 |
| 2-2 | 25 | - | 25 | - | - | - | - | - | - | - | - | - | 50 | - | 3 | 100 | 1565 |
| 2-3 | 25 | - | - | 25 | - | - | - | - | - | - | - | - | 50 | - | 3 | 100 | 1570 |
| 2-4 | 25 | - | - | - | 25 | - | - | - | - | - | - | - | 50 | - | 3 | 100 | 1550 |
| 2-5 | 25 | - | - | - | - | 25 | - | - | - | - | - | - | 50 | - | 3 | 100 | 1545 |
| 2-6 | 25 | - | - | - | - | - | 25 | - | - | - | - | - | 50 | - | 3 | 100 | 1530 |
| 2-7 | 25 | - | - | - | - | - | - | 25 | - | - | - | - | 50 | - | 3 | 100 | 1555 |
| 2-8 | 25 | - | - | - | - | - | - | - | 25 | - | - | - | 50 | - | 3 | 100 | 1525 |
| 2-9 | 25 | - | - | - | - | - | - | - | - | 25 | - | - | 50 | - | 3 | 100 | 1650 |
| 2-10 | 25 | - | - | - | - | - | - | - | - | - | 25 | - | 50 | - | 3 | 100 | 1600 |

**[Table 6]**

| sample nos. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 3-1 | 25 | 25 | - | - | - | - | - | - | - | - | - | 25 | 25 | - | 3 | 100 | 1542 |
| 3-2 | 25 | - | 25 | - | - | - | - | - | - | - | - | 25 | 25 | - | 3 | 100 | 1569 |
| 3-3 | 25 | - | - | 25 | - | - | - | - | - | - | - | 25 | 25 | - | 3 | 100 | 1572 |
| 3-4 | 25 | - | - | - | 25 | - | - | - | - | - | - | 25 | 25 | - | 3 | 100 | 1552 |
| 3-5 | 25 | - | - | - | - | 25 | - | - | - | - | - | 25 | 25 | - | 3 | 100 | 1547 |
| 3-6 | 25 | - | - | - | - | - | 25 | - | - | - | - | 25 | 25 | - | 3 | 100 | 1532 |
| 3-7 | 25 | - | - | - | - | - | - | 25 | - | - | - | 25 | 25 | - | 3 | 100 | 1557 |
| 3-8 | 25 | - | - | - | - | - | - | - | 25 | - | - | 25 | 25 | - | 3 | 100 | 1527 |
| 3-9 | 25 | - | - | - | - | - | - | - | - | 25 | - | 25 | 25 | - | 3 | 100 | 1640 |
| 3-10 | 25 | - | - | - | - | - | - | - | - | - | 25 | 25 | 25 | - | 3 | 100 | 1602 |
| 3-11 | 33 | - | - | - | - | - | - | - | - | - | - | 33 | 33 | - | 3 | 100 | 1550 |
| 3-12 | 17 | - | - | - | - | - | - | - | - | 16 | 17 | 25 | 25 | - | 3 | 100 | 1530 |
| 3-13 | - | - | - | - | - | - | - | - | - | 25 | 25 | 25 | 25 | - | 3 | 100 | 1450 |

**[Table 7]**

| sample nos. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 4-1 | 25 | 25 | - | - | - | - | - | - | - | - | - | 50 | - | - | 3 | 100 | 1543 |
| 4-2 | 25 | - | 25 | - | - | - | - | - | - | - | - | 50 | - | - | 3 | 100 | 1568 |
| 4-3 | 25 | - | - | 25 | - | - | - | - | - | - | - | 50 | - | - | 3 | 100 | 1573 |
| 4-4 | 25 | - | - | - | 25 | - | - | - | - | - | - | 50 | - | - | 3 | 100 | 1553 |
| 4-5 | 25 | - | - | - | - | 25 | - | - | - | - | - | 50 | - | - | 3 | 100 | 1548 |
| 4-6 | 25 | - | - | - | - | - | 25 | - | - | - | - | 50 | - | - | 3 | 100 | 1533 |
| 4-7 | 25 | - | - | - | - | - | - | 25 | - | - | - | 50 | - | - | 3 | 100 | 1558 |
| 4-8 | 25 | - | - | - | - | - | - | - | 25 | - | - | 50 | - | - | 3 | 100 | 1528 |
| 4-9 | 25 | - | - | - | - | - | - | - | - | 25 | - | 50 | - | - | 3 | 100 | 1638 |
| 4-10 | 25 | - | - | - | - | - | - | - | - | - | 25 | 50 | - | - | 3 | 100 | 1603 |

**[Table 8]**

| sample nos. | coating film | | | | | | | | | | | | | | | | | | | grinding ratio |
|---|---|---|---|---|---|---|---|---|---|---|---|---|---|---|---|---|---|---|---|---|
| | composition (atomic %) | | | | | | | | | | | | | | | | | average crystal grain size (nm) | average thickness (nm) | |
| | Ti | V | Cr | Zr | Y | Mg | Ca | Nb | Mo | Hf | Ta | W | Al | Si | C | N | O | | | |
| 5-1 | 33 | - | - | - | - | - | - | - | - | - | - | - | - | - | - | - | 67 | 3 | 100 | 1350 |
| 5-2 | - | - | 40 | - | - | - | - | - | - | - | - | - | - | - | - | - | 60 | 3 | 100 | 1430 |
| 5-3 | - | - | - | 33 | - | - | - | - | - | - | - | - | - | - | - | - | 67 | 3 | 100 | 1500 |
| 5-4 | - | - | - | - | - | - | - | - | - | 33 | - | - | - | - | - | - | 67 | 3 | 100 | 1330 |
| 5-5 | - | - | - | - | - | - | - | - | - | - | 29 | - | - | - | - | - | 71 | 3 | 100 | 1360 |
| 5-6 | - | - | - | - | - | - | - | - | - | - | - | 25 | - | - | - | - | 75 | 3 | 100 | 1320 |
| 5-7 | - | - | - | - | - | - | - | - | - | - | - | - | 40 | - | - | - | 60 | 3 | 100 | 1510 |
| 5-8 | - | - | - | - | - | - | - | - | - | - | - | - | - | 33 | - | - | 67 | 3 | 100 | 1340 |
| 5-9 | - | - | - | - | 40 | - | - | - | - | - | - | - | - | - | - | - | 60 | 3 | 100 | 1340 |
| 5-10 | - | - | - | - | - | 50 | - | - | - | - | - | - | - | - | - | - | 50 | 3 | 100 | 1350 |
| 5-11 | - | - | - | - | - | - | 50 | - | - | - | - | - | - | - | - | - | 50 | 3 | 100 | 1330 |

**[Table 9]**

| sample nos. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 6-1 | 22.5 | - | - | 5 | - | - | - | - | - | 22.5 | - | - | 50 | - | 3 | 100 | 1595 |
| 6-2 | 22.5 | - | - | - | 5 | - | - | - | - | 22.5 | - | - | 50 | - | 3 | 100 | 1580 |
| 6-3 | 22.5 | - | - | - | - | - | - | 5 | - | 22.5 | - | - | 50 | - | 3 | 100 | 1590 |
| 6-4 | 22.5 | - | - | - | - | - | - | - | - | 22.5 | 5 | - | 50 | - | 3 | 100 | 1620 |
| 6-5 | - | - | 15 | - | - | - | - | - | - | 35 | - | - | 50 | - | 3 | 100 | 1610 |
| 6-6 | - | - | 25 | - | - | - | - | - | - | 25 | - | - | 50 | - | 3 | 100 | 1600 |
| 6-7 | - | - | | - | - | - | - | - | - | - | - | 100 (DLC) | - | - | 3 | 100 | 1400 |
| 6-8 | - | - | | - | - | - | - | - | - | - | - | 100 (diamond) | - | - | 3 | 100 | 1500 |

As shown in Tables 5 to 9, whichever composition the coating film may have, sample No. 2 type samples to sample No. 6 type samples having a coating film with a small average crystal grain diameter all presented a grinding ratio of 1200 or more, and furthermore, 1300 or more, and it can be seen that it is higher than that of sample No. 101 of test example 1. Inter alia, all of Sample No. 2 type samples, sample Nos. 3-1 to 3-12, all of Sample No. 4 type samples, sample Nos. 5-3, 5-8, 6-1 to 6-6 and 6-8 all presented a grinding ratio of 1500 or more, and it can be seen that it is significantly high.

### <<Test Example 3>>

Difference in grinding performance due to difference in thickness of coating films of super-abrasive grains was evaluated.

### [Sample Nos. 7-1 to 7-7]

Sample Nos. 7-1 to 7-7 were prepared to be similar to Sample No. 1-7 except that the former had their super-abrasive grains with their coating films made different in thickness, as shown in Table 10, and the samples were evaluated in grinding performance. The coating films were made different in thickness by adjusting a processing time. The longer the processing time is, the thicker the coating film is. A result of grinding ratios of sample Nos. 7-1 to 7-7 is shown in table 10.

**[Table 10]**

| sample nos. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 7-1 | 25 | - | - | - | - | - | - | - | - | 25 | - | - | 50 | - | 3 | 0.5 | 1150 |
| 7-2 | 25 | - | - | - | - | - | - | - | - | 25 | - | - | 50 | - | 3 | 1 | 1530 |
| 7-3 | 25 | - | - | - | - | - | - | - | - | 25 | - | - | 50 | - | 3 | 10 | 1550 |
| 7-4 | 25 | - | - | - | - | - | - | - | - | 25 | - | - | 50 | - | 3 | 100 | 1700 |
| 7-5 | 25 | - | - | - | - | - | - | - | - | 25 | - | - | 50 | - | 3 | 1000 | 1832 |
| 7-6 | 25 | - | - | - | - | - | - | - | - | 25 | - | - | 50 | - | 3 | 5000 | 1500 |
| 7-7 | 25 | - | - | - | - | - | - | - | - | 25 | - | - | 50 | - | 3 | 8000 | 1230 |

As shown in Table 10, sample Nos. 7-2 to 7-7 having a coating film with a small average crystal grain size and an average thickness of 1 nm or more all presented a grinding ratio of 1200 or more, and it can be seen that it is higher than that of Sample No. 7-1 having a coating film with an average thickness of less than 1 nm and that of sample No. 101 in test example 1 having a coating film with a large average crystal grain size. Inter alia, it can be seen that sample Nos. 7-2 to 7-6 having a coating film with an average thickness of 1 nm or more and 5000 nm or less present a grinding ratio higher than that of Sample No. 7-7 having a coating film with an average thickness exceeding 5000 nm.

### <<Test Example 4>>

Difference in grinding performance due to different structures of coating films of super-abrasive grains was evaluated.

### [Sample Nos. 8-1 and 8-2]

Sample Nos. 8-1 and 8-2 were prepared to be similar to those in test example 1 except that the former had their super-abrasive grains with their coating films having a multilayer structure composed of a plurality of stacked ceramic layers, as shown in Table 11, and the samples were evaluated in grinding performance. Sample No. 8-1 had a coating film in a two-layer structure, and Sample No. 8-2 had a coating film in a three-layer structure. Sample No. 8-1 had a first layer on the side of the body of the abrasive grain and a second layer outer than the first layer, and the first and second layers are composed of different materials. When Sample No. 8-2 has first to third layers sequentially as seen on the side of the body of the abrasive grain outward, the first and third layers are formed of identical materials and the first layer (and the third layer) and the second layer are formed of different materials. The layers are equal in average crystal grain size and average thickness. The coating film having the two-layer structure was formed by performing a coating process twice and the coating film having the three-layer structure was formed by performing the coating process three times.

**[Table 11]**

| sample nos. | | coating film | | | | | | | | | | | | | | | | grinding ratio |
|---|---|---|---|---|---|---|---|---|---|---|---|---|---|---|---|---|---|---|
| | | composition (atomic %) | | | | | | | | | | | | | | average crystal grain size (nm) | average thickness (nm) | |
| | | Ti | V | Cr | Zr | Nb | Mo | Hf | Ta | W | Al | Si | C | N | O | | | |
| 8-1 | 1st layer | 25 | - | - | - | - | - | - | - | - | 25 | - | - | 50 | - | 3 | 50 | 1700 |
| | 2nd layer | - | - | 25 | - | - | - | - | - | - | 25 | - | - | 50 | - | 3 | 50 | |
| 8-2 | 1st laver | 25 | - | - | - | - | - | - | - | - | 25 | - | - | 50 | - | 3 | 33.33 | 1740 |
| | 2nd layer | - | - | 25 | - | - | - | - | - | - | 25 | - | - | 50 | - | 3 | 33.33 | |
| | 3rd layer | 25 | - | | - | - | - | - | - | - | 25 | - | - | 50 | - | 3 | 33.33 | |

As shown in Table 11, Sample Nos. 8-1 and 8-2 have a grinding ratio of 1700 or more, and it can be seen that when a case with a coating film of a monolayer structure is compared with that with a coating film having a larger number of layers, the latter tends to present a higher grinding ratio.

### <<Test Example 5>>

After a super-abrasive grinding wheel was produced it was coated with a coating film, and the thus coated wheel was evaluated for difference in grinding performance due to different crystal grain sizes of the coating film.

### [Sample No. 9-1]

Sample No. 9-1 is different in how a super-abrasive grinding wheel is produced. This super-abrasive grinding wheel was produced as follows: a plurality of bodies for abrasive grains that were not coated with a coating film were prepared, and a bonding material was used to fix the bodies for abrasive grains to the outer peripheral surface of the disk-shaped substrate and subsequently the coating film was formed to coat a cutting edge portion of the bodies for abrasive grains. The coating film was applied in the arc plasma powder method. The coating was done with a coating apparatus under conditions, as indicated below. Using this super-abrasive grinding wheel, grinding performance was evaluated in the same manner as in Test Example 1. A result thereof is shown in table 12.
Coating apparatus: nanoparticle formation apparatus APD-P produced by ADVANCE RIKO, Inc.
Target: 50 atomic% of Ti and 50 atomic% of Al
Introduced gas: N₂
Deposition pressure: 0.88 Pa
Discharge voltage: 150 V
Discharge frequency: 6 Hz
Capacitor's capacitance: 1080 µF
Shot count: 1,000
Speed of rotation of powder container: 50 rpm

**[Table 12]**

| sample no. | coating film | | | | | | | | | | | | | | | | grinding ratio |
|---|---|---|---|---|---|---|---|---|---|---|---|---|---|---|---|---|---|
| | composition (atomic %) | | | | | | | | | | | | | | average crystal grain size (nm) | average thickness (nm) | |
| | Ti | V | Cr | Zr | Nb | Mo | Hf | Ta | W | Al | Si | C | N | O | | | |
| 9-1 | 25 | - | - | - | - | - | - | - | - | 25 | - | - | 50 | - | 3 | 400 | 1620 |

As shown in Table 12, Sample No. 9-1 presents a grinding ratio of 1600 or more and is found to be very high. Thus it can be seen that the grinding ratio can be improved by coating the surface of the body of the abrasive grain with the coating film.

It is believed that even if the coating film does not coat the surface of the body of the abrasive grain entirely, the coating film has an effect in improving the grinding ratio insofar as the coating film coats the surface at least partially. For example, even if truing a super-abrasive grinding wheel to have a surface uniform in level or the like results in an abrasive grain having a body with a cutting edge portion having a surface locally uncoated with the coating film, it is believed to be effective in improving the grinding ratio insofar as the cutting edge portion has the surface with a 50% or more thereof in area coated with the coating film.

### <<Test Example 6>>

Difference in grinding performance depending on presence/absence of the insulating film on the outer surface of the coating film of the super-abrasive grain was evaluated.

### [Sample Nos. 10-1 to 10-8]

Sample Nos. 10-1 to 10-8 provided super-abrasive grains each composed of a body, a coating film coating the entire surface area of the body, and an insulating film covering the entire surface area of the coating film. The insulating film was formed under the same conditions using the coating apparatus of Test Example 1. Sample Nos. 10-1 to 10-8 had the same body and coating film as those of Sample No. 2-9. Sample Nos. 10-1 to 10-3 had insulating films made different in composition, as shown in table 13. The different compositions were provided by variously changing the type of the target in the coating apparatus and the atmosphere in the apparatus. Sample Nos. 10-4 to 10-8 had their insulating films identical in composition to that of Sample No. 10-1 and made different in average thickness. Difference in average thickness was provided by adjusting a processing time. The longer the processing time is, the thicker the insulating film is.

Using this super-abrasive grain, a super-abrasive grinding wheel was produced in the same manner as in Test Example 1 except for the type of the bonding material. In this example, the bonding material is composed of a nickel plating layer. Initially, an area of the substrate excluding the outer peripheral surface is masked to expose the outer peripheral surface through the masking. A nickel plating layer is precipitated on the exposed outer peripheral surface of the substrate by electroplating to temporarily attach super-abrasive grains. Then, on a surface of the nickel plating layer, a nickel plating layer was applied thickly by electroless plating to fix super-abrasive grains to the outer peripheral surface of the substrate.

Using this super-abrasive grinding wheel, grinding performance was evaluated, similarly as done in test example 1. A result thereof is shown in Table 13.

### [Sample Nos. 105 and 106]

Sample No. 105 provided a super-abrasive grain identical to that of sample No. 2-9, that is, excluding the insulating film and composed of the body for the abrasive grain and the coating film. Sample No. 106 provided a super-abrasive grain identical to that of sample No. 101, that is, excluding the coating film and the insulating film and composed only of the body for the abrasive grain. As well as Sample No. 10-1 or the like, Sample Nos. 105 and 106 had super-abrasive grains fixed to the outer peripheral surface of the substrate by a nickel plating layer through electroplating and electroless plating.

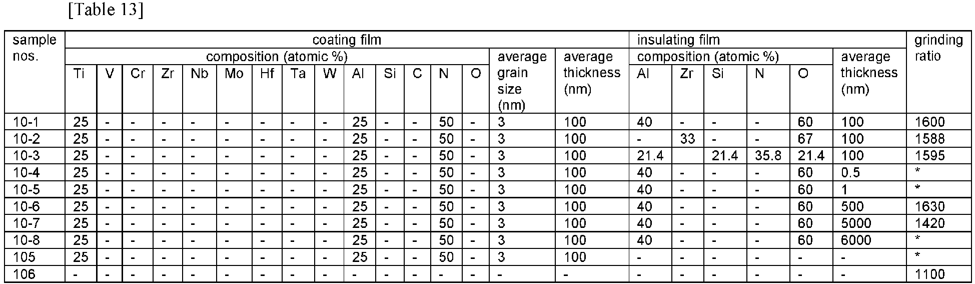

As shown in Table 13, it can be seen that Sample Nos. 10-1 to 10-3, 10-6, and 10-7 having an insulating film with an average thickness of more than 1 nm and 5000 nm or less present a high grinding ratio.

In contrast, Sample Nos. 10-4, 10-5, 10-8, and 105 caused a defect inviting impaired grinding performance. The ground therefor is as follows: Sample No. 10-4 had an insulating film with an average thickness of less than 1 nm and was unable to increase insulation, allowing a plating film to grow on a surface of the insulating film. Sample No. 10-5 had an insulating film with an average thickness of 1 nm, and a portion having low insulating performance was locally formed and a plating film locally grew on a surface of the insulating film. Sample No. 10-8 had an insulating film with an average thickness of 6000 nm and thus excessively large in thickness so that it was unable to maintain a state of covering the outer surface of the coating film. As a result, a plating film grew, similarly as seen in Sample No. 10-4. Sample No. 105 had no insulating film and in addition, had an electrically conductive coating film, and accordingly, a plating film grew on a surface of the coating film.

Although Sample No. 106 neither had a coating film nor an insulating film and had no plating film growing on a surface of the body of the abrasive grain, the sample presented a low grinding ratio due to the absence of the coating film.

Note that the present invention is not limited to these examples, and is intended to include any modifications within the meaning and scope indicated by and equivalent to the terms of the claims.

### REFERENCE SIGNS LIST

1 super-abrasive grain, 2 body of abrasive grain, 3 coating film, 31 first layer, 32 second layer, 33 third layer, 4 insulating film, 10 super-abrasive grinding wheel, 11 substrate, 111 outer peripheral surface, 12 super-abrasive grain layer, 13 bonding material.

## Claims

1. A super-abrasive grain comprising:
a body composed of cubic boron nitride or diamond; and
a ceramic coating film coating at least a portion of a surface of the body.

2. The super-abrasive grain according to claim 1, wherein the body has a single-crystal structure.

3. The super-abrasive grain according to claim 1, wherein the body has a polycrystalline structure.

4. The super-abrasive grain according to any one of claims 1 to 3, wherein the coating film has an average crystal grain size of 500 nm or less.

5. The super-abrasive grain according to claim 4, wherein the coating film has an average crystal grain size of 50 nm or less.

6. The super-abrasive grain according to any one of claims 1 to 5, wherein the coating film contains one selected from the following (a) and (b):
(a) a nitride, a carbide, a carbonitride, an oxide, or an oxynitride containing one or more elements selected from group 4 elements, group 5 elements and group 6 elements in the periodic table, Al, Si, Y, Mg, and Ca; and
(b) diamond-like carbon or diamond.

7. The super-abrasive grain according to any one of claims 1 to 6, wherein the coating film is composed of (Ti_{1-xb1-yb1}Si_{xb1}Ml_{yb1})(C_{1-zb1}N_{zb1}), or (Al_{1-xb2}M2_{xb2})(C_{1-zb2}N_{zb2}), where
M1 = one or more elements selected from group 4 elements, group 5 elements and group 6 elements in the periodic table, and Al (Note that Ti is excluded),
xb1 = 0 or more and 0.45 or less,
yb1 = 0 or more and 0.5 or less,
zb1 = 0.2 or more and 0.5 or less, and
M2 = one or more elements selected from group 4 elements, group 5 elements and group 6 elements in the periodic table, and Si,
xb2 = 0.025 or more and 0.475 or less,
zb2 = 0.2 or more and 0.5 or less.

8. The super-abrasive grain according to any one of claims 1 to 7, wherein the coating film has a thickness of 1 nm or more and 5000 nm or less.

9. The super-abrasive grain according to any one of claims 1 to 8, wherein the coating film has a multilayer structure composed of a plurality of stacked ceramic layers.

10. The super-abrasive grain according to any one of claims 1 to 9, further comprising an insulating film covering an outer surface of the coating film.

11. The super-abrasive grain according to claim 10, wherein the insulating film includes a compound of any one of an oxide and an oxynitride containing one or more elements selected from Al, Si, Zr, and Ti.

12. The super-abrasive grain according claim 10 or 11, wherein the insulating film has a thickness of 1 nm or more and 5000 nm or less.

13. The super-abrasive grain according to any one of claims 1 to 12, wherein the body has a grain size of 1 µm or more and 600 µm or less.

14. A super-abrasive grinding wheel comprising:
a disk-shaped substrate; and
a super-abrasive grain layer covering at least an outer peripheral surface of the substrate,
the super-abrasive grain layer having the super-abrasive grain according to any one of claims 1 to 13.
